# FASCICULE DE BREVET EUROPEEN

(11) **EP 0 851 554 B1**
(45) Date de publication et mention de la délivrance du brevet: **30.06.2004**
(21) Numéro de dépôt: 97410149.5
(22) Date de dépôt: 22.12.1997
(51) Int. Cl.: H02H 3/33, G01R 11/24

(54) **Disjoncteur comportant un dispositif de commande d'ouverture et dispositif de distribution électrique comportant un tel disjoncteur**
Schutzschalter mit Vorrichtung zum Steueren des Öffnens und elektrische Verteilervorrichtung mit solchem Schalter
Circuit breaker containing an opening control device and electrical distribution device with such a breaker

(30) Priorité: 23.12.1996 FR 9616148
(43) Date de publication de la demande: 01.07.1998
(73) Titulaire: Schneider Electric Industries SAS, 92500 Rueil-Malmaison (FR)
(72) Inventeur: Routier, Gontran, 38050 Grenoble cedex 09 (FR)
(74) Mandataire: Jouvray, Marie-Andrée

(56) Documents cités:
- FR-A- 2 643 195
- GB-A- 2 227 846
- GB-A- 2 260 415

## Description

L'invention concerne un disjoncteur électrique comportant des contacts électriques principaux destinés à interrompre un courant électrique dans une installation, un dispositif de déclenchement commandant l'ouverture des contacts principaux lorsqu'un défaut électrique se produit dans l'installation, des bornes de commande d'ouverture recevant un signal de commande et un dispositif de commande d'ouverture connecté entre les bornes de commande d'ouverture et le dispositif de déclenchement pour commander l'ouverture du disjoncteur en fonction du signal de commande.

Des disjoncteurs connus comportent des dispositifs de commande permettant de commander à distance l'ouverture des contacts du disjoncteur. Généralement, ces dispositifs de commande comportent des bobines auxiliaires à maximum de tension ou à minimum de tension. Les bobines commandent l'ouverture du disjoncteur lorsque la tension qui leur est appliquée passe respectivement au-dessus ou au-dessous d'un seuil de tension.

Dans des disjoncteurs comportant un dispositif de protection différentielle, les dispositifs de commande sont associés à des dispositifs de test. Un dispositif de protection différentielle comporte généralement un tore, entourant l'ensemble des conducteurs principaux d'un disjoncteur, pour mesurer un courant différentiel ou de fuite à la terre. Le dispositif de test dérive un courant extérieur au tore entre un conducteur en amont et un conducteur en aval du tore. La valeur du courant dérivé est détectée par le tore qui actionne un relais de déclenchement. Pendant le test, le courant dérivé traverse un bouton poussoir à fermeture et une résistance connectés en série.

Pour commander l'ouverture d'un disjoncteur comportant une protection différentielle, il est connu d'utiliser un interrupteur extérieur à fermeture. Cet interrupteur est connecté en parallèle sur le contact à fermeture du bouton poussoir de test à travers deux bornes auxiliaires du disjoncteur. Ce mode de réalisation d'un dispositif de commande est plus économique que celui qui utilise des bobines à maximum ou à minimum de tension.

Lorsque le disjoncteur doit être connecté à un dispositif de contrôle pouvant donner des ordres d'ouverture au disjoncteur, la liaison entre le dispositif de contrôle et le disjoncteur doit être sécurisée.

La commande d'ouverture doit être sécurisée, notamment, lorsqu'un distributeur d'énergie électrique veut contrôler la distribution d'électricité fournie à des utilisateurs. Les dispositifs de commande doivent, dans ce cas, limiter les risques de fraude et garantir une ouverture sûre des disjoncteurs.

Les dispositifs de commande connus ne permettent pas une liaison suffisamment sûre. En effet, les dispositifs de commande comportant des bobines à maximum de tension et les dispositifs comportant une mise en parallèle de contacts sur le circuit test, ne permettent plus l'ouverture du disjoncteur si la liaison est interrompue ou coupée. Les dispositifs de commande comportant des bobines à minimum de tension sont un peu plus fiables mais il est possible de frauder en forçant la commande de la bobine à une tension d'alimentation fixe.

L'invention a pour but un dispositif de commande permettant une commande sécurisée de l'ouverture du disjoncteur, et un dispositif de distribution permettant interruption sécurisée de la fourniture d'énergie électrique.

Selon l'invention le disjoncteur est caractérisé en ce que le dispositif de commande comporte :
- des moyens de détection d'un signal électrique connectés à au moins une des bornes de commande d'ouverture,
- des moyens de comparaison connectés entre les moyens de détection et le dispositif de déclenchement pour comparer le signal électrique à une valeur prédéterminée et provoquer une commande d'ouverture du disjoncteur si le signal est inférieur à la valeur prédéterminée.

Selon un mode préférentiel de réalisation, le dispositif de commande comporte un circuit d'alimentation électrique ayant une entrée connectée aux contacts principaux et une sortie connectée à une des bornes de commande.

Selon un mode particulier de réalisation de l'invention, les moyens de détection comportent des moyens d'isolation électrique connectés entre les bornes de commande d'ouverture et les moyens de comparaison.

De préférence, les moyens d'isolation électrique comportent un opto-coupleur connecté entre au moins une borne et les moyens de comparaison.

Selon un premier développement de l'invention, les moyens de comparaison comportent des moyens de décodage connectés entre les moyens de détection et le dispositif de déclenchement.

Les moyens de comparaison commandent également l'ouverture du disjoncteur si le signal détecté par les moyens de détection n'a pas des caractéristiques prédéterminées.

Selon une première variante, les moyens de comparaison commandent l'ouverture du disjoncteur si le signal détecté par les moyens de détection a une valeur continue inférieure à une valeur prédéterminée.

Selon une seconde variante, les moyens de comparaison commandent également l'ouverture du disjoncteur si le signal détecté par les moyens de détection a une valeur différente d'un signal périodique de période et de rapport cyclique prédéterminés.

Selon une troisième variante, les moyens de comparaison commandent également l'ouverture du disjoncteur si le signal détecté par les moyens de détection a une valeur différente d'un signal codé binaire prédéterminé.

Selon un second développement de l'invention, le disjoncteur comporte un dispositif de visualisation connecté aux moyens de commande pour visualiser si l'ouverture du disjoncteur a été provoquée par un signal de commande.

Le dispositif de visualisation comporte un premier voyant pour visualiser une ouverture du disjoncteur provoquée par un signal de commande, et au moins un second voyant pour visualiser une ouverture provoquée par des dispositifs de protection électrique.

Selon un troisième développement de l'invention, le dispositif de commande comporte des moyens de validation connectés aux contacts principaux pour autoriser l'ouverture du disjoncteur par le signal de commande lorsqu'une tension d'alimentation est présente sur lesdits contacts principaux du disjoncteur.

L'invention concerne aussi un dispositif de distribution électrique comportant un disjoncteur selon des caractéristiques ci-dessus et un dispositif de contrôle connecté aux bornes de commande.

Dans un mode préférentiel de réalisation, le dispositif de contrôle comporte des moyens d'interruption connectés aux bornes de commandes du disjoncteur pour interrompre le courant circulant entre deux desdites bornes.

Selon un mode particulier de réalisation, le dispositif de contrôle comporte des moyens de codage pour coder le signal de commande envoyé aux bornes de commande du disjoncteur.

Dans une installation électrique, le dispositif de contrôle peut comporter une entrée connectée à une sortie d'un dispositif de réception à courants porteurs et/ou une entrée connectée à une sortie d'un dispositif de pré-payement.

D'autres avantages ressortiront plus clairement de la description qui va suivre, de modes particuliers de réalisation de l'invention, donnés à titre d'exemples non limitatifs, et représentés aux dessins annexés sur lesquels :
La figure 1 représente un premier mode de réalisation d'un dispositif de distribution et d'un disjoncteur selon l'invention.
La figure 2 représente un second mode de réalisation d'un dispositif de distribution et d'un disjoncteur selon l'invention.
La figure 3 représente un troisième mode de réalisation d'un dispositif de distribution et d'un disjoncteur selon l'invention.
La figure 4 représente un schéma d'un disjoncteur selon un mode de réalisation de l'invention comportant un dispositif de signalisation.
La figure 5 représente un schéma d'un dispositif de distribution selon un mode de réalisation de l'invention dans une installation électrique.

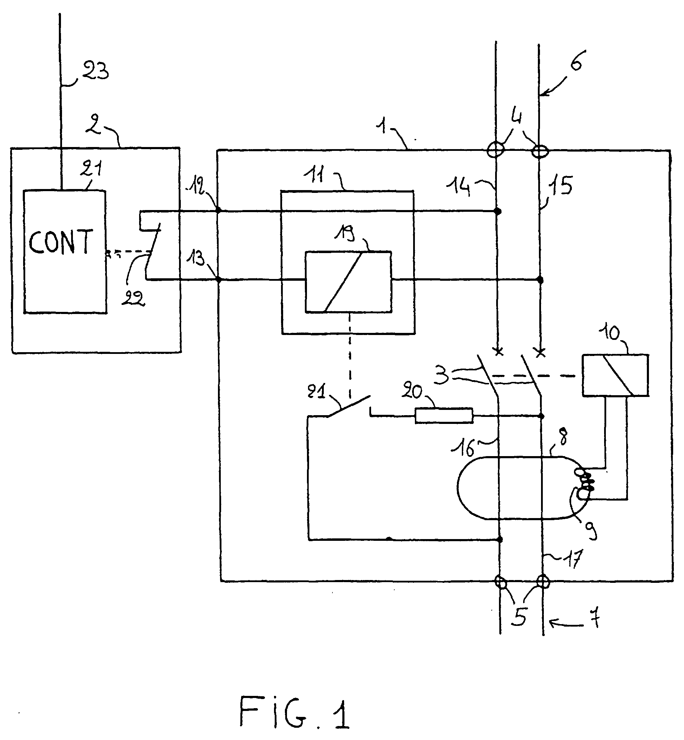

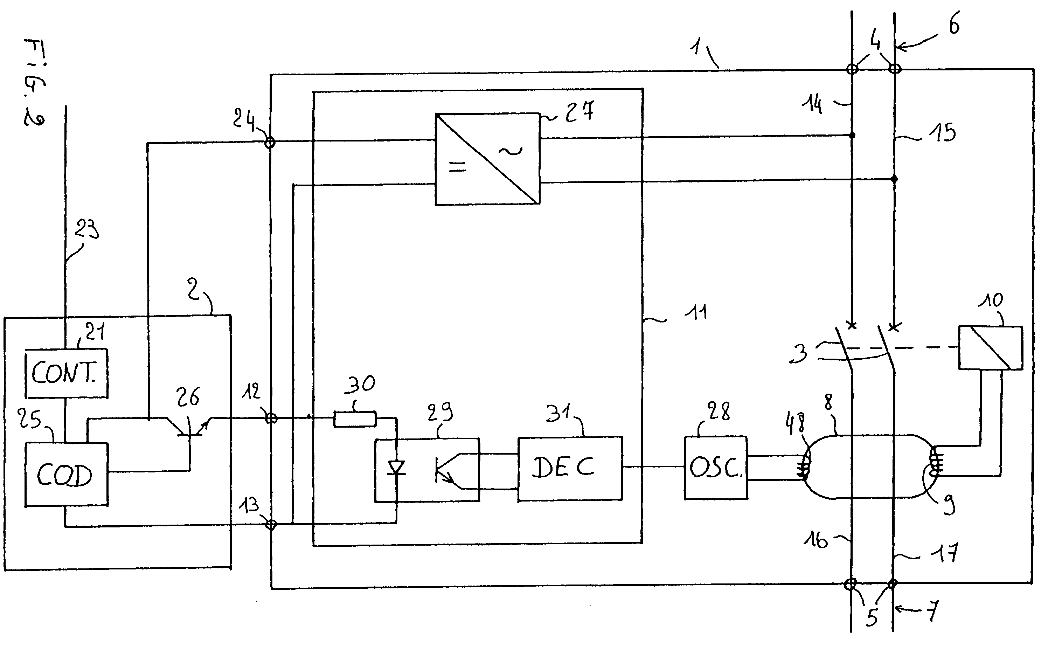

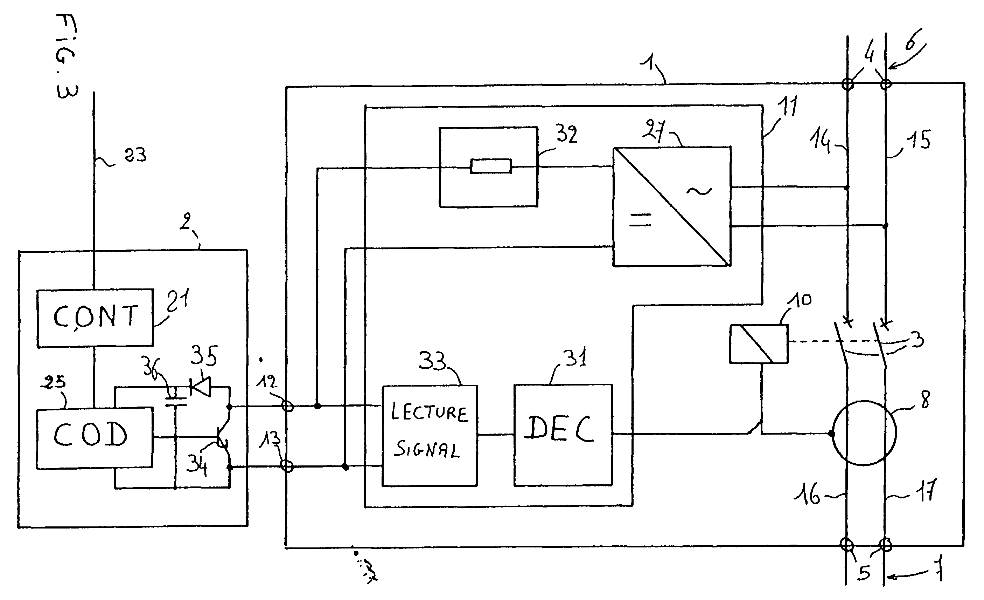

Le schéma de la figure 1 montre un dispositif de distribution selon un premier mode de réalisation de l'invention comportant un disjoncteur 1 et un dispositif de contrôle 2.

Le disjoncteur 1 comporte des contacts principaux 3 connectés entre des bornes 4 de raccordement amont à travers des liaisons 14 et 15 et des bornes 5 de raccordement aval à travers des liaisons 16, 17. Les bornes 4 de raccordement amont sont reliées à une ligne 6 d'alimentation et les bornes 5 sont reliées à une ligne 7 de distribution.

Dans ce mode de réalisation, le disjoncteur 1 est de type différentiel comportant un tore 8 entourant l'ensemble des conducteurs reliant les contacts 3 principaux aux bornes 5 de raccordement aval. Le tore 8 comporte un premier bobinage 9 secondaire connecté à un relais de déclenchement 10. Lorsqu'un courant différentiel ou de fuite à la terre apparaît dans la ligne de distribution, un courant est induit dans le bobinage 9 secondaire qui alimente un relais 10. Si le courant induit dépasse une valeur prédéterminée, le relais 10 actionne l'ouverture des contacts 3 principaux.

Selon ce premier mode de réalisation, le disjoncteur 1 comporte un dispositif 11 de commande d'ouverture connecté entre deux bornes 12 et 13 de commande et les liaisons 14 et 15. Le dispositif 11 commande l'ouverture du disjoncteur en fonction d'un signal électrique représentatif du courant circulant dans les bornes 12 et 13 de commande.

Dans le disjoncteur de la figure 1, le dispositif de commande 11 comporte un circuit 19 de détection et de comparaison de courant connecté entre la borne de commande 13 et la liaison 15. La borne 12 est connectée à la ligne 14. Lorsque le contact 22 est ouvert, le courant circulant à travers la borne 13 et le circuit 19 devient inférieur à une valeur prédéterminée, le circuit 19 provoque l'ouverture du disjoncteur.

L'ouverture du disjoncteur peut être réalisée en commandant directement le relais 10 de déclenchement par une sortie du dispositif 11. Dans le disjoncteur de la figure 1, le circuit 19 est un relais électromagnétique fermant un contact 21 lorsque le courant qui traverse la bobine du relais devient inférieur à une valeur prédéterminée.

La commande de l'ouverture du disjoncteur est réalisée à l'aide du tore 8 de protection différentielle. Le contact 21 est connecté en série avec une résistance 20 entre la liaison 16 et la liaison 17.

Lorsque le dispositif 11 commande l'ouverture du disjoncteur, le contact 21 est fermé. Un courant circule alors entre la résistance 20 de limitation et le contact 21. Ce courant circulant à l'extérieur du tore induit un flux magnétique dans le tore 8 et un courant secondaire dans le bobinage 9. Le courant secondaire alimente le relais qui déclenche l'ouverture de l'appareil. Le courant induit est proportionnel à la tension entre les liaisons 16 et 17. Dans ce mode de commande préférentiel, l'ouverture du disjoncteur peut donc être commandée lorsqu'une tension d'alimentation suffisante est présente sur les liaisons 16 et 17.

Le dispositif 2 de contrôle de la figure 1 comporte un circuit de contrôle 21 et un contact à ouverture 22 commandé par ledit circuit 21. Le contact 22 est connecté aux bornes de commande 12 et 13 du disjoncteur.

Le circuit de contrôle 21 reçoit des signaux 23 d'information. Si les signaux 23 véhiculent un ordre d'ouverture du disjoncteur, le circuit de contrôle ouvre le contact 22 et interrompt le courant circulant dans la borne 13. Le circuit 19 du disjoncteur détecte une baisse ou l'annulation du courant le traversant, puis commande l'ouverture des contacts 3 du disjoncteur.

La commande de l'ouverture du disjoncteur est fiabilisée par le fait que, si les bornes 12 ou 13 sont déconnectées ou si les liaisons entre lesdites bornes et le dispositif 2 sont coupées, le courant circulant dans le circuit 19 est inférieur à une valeur de référence prédéterminée et le disjoncteur est automatiquement en commande d'ouverture.

Un second mode de réalisation d'un disjoncteur et d'un dispositif de distribution selon l'invention est représenté sur la figure 2. Le dispositif de commande 11 comporte un circuit d'alimentation 27 ayant une entrée connectée aux liaisons 14 et 15, et une sortie connectée entre la borne 13 de commande et une troisième borne 24 de commande du disjoncteur.

Le dispositif de contrôle 2 représenté sur la figure 2 comporte le circuit 21 de contrôle recevant les signaux 23, un circuit de codage 25 connecté à une sortie du circuit 21 et un transistor 26 commandé par le circuit 25. Le circuit 25 est connecté à la borne 13 et à la borne 24 pour recevoir l'alimentation électrique fournie par le circuit 27. Le transistor 26 est connecté entre la liaison d'alimentation, venant de la borne 24 et la borne 12.

Lorsque le circuit 21 de contrôle reçoit un ordre d'ouverture, il commande, à travers le circuit 25 de codage, l'ouverture du transistor 26. Le courant dans la borne 12 est alors interrompu et le dispositif 11 commande l'ouverture du disjoncteur 1.

Si l'une des trois bornes 12, 13 ou 24 est déconnectée le courant circulant dans la borne 12 est automatiquement réduit ou annulé et le dispositif 11 commande l'ouverture du disjoncteur. Les bornes 13 et 24 alimentent le circuit 25 qui ne peut pas fermer le transistor 26 en l'absence d'alimentation.

La sortie de commande d'ouverture du dispositif 11 est appliquée à une entrée d'un oscillateur 28. Lors de la commande d'ouverture, l'oscillateur 28 alimente en courant alternatif un second bobinage 48 du tore 8. Le courant alternatif induit un flux magnétique dans le tore et un courant secondaire dans le premier bobinage secondaire 9. Ensuite, le courant secondaire alimente le relais de déclenchement 10 pour ouvrir le disjoncteur.

Le dispositif 11 comporte un opto-coupleur 29 pour détecteur le courant circulant à travers la borne 12 et garantir un isolement électrique entre des circuits du disjoncteur et les bornes de commande. L'entrée de l'opto-coupleur en série avec une résistance 30 de limitation est connectée entre les bornes 12 et 13 de commande. En fonctionnement normal, un courant fourni par le circuit d'alimentation 27, passe par la borne 24, traverse le transistor 26 du dispositif 2, la borne 12, la résistance 30 et une diode émettrice de l'opto-coupleur. Ensuite, le courant revient vers le circuit d'alimentation 27 par la ligne de l'alimentation connectée à la borne 13. Si le courant est suffisant, un transistor récepteur de sortie de l'opto-coupleur 29 envoie un signal de présence de courant à un circuit 31 de décodage connecté entre l'opto-coupleur et l'oscillateur.

Si le courant est interrompu par l'ouverture du transistor 26 ou par la rupture d'une liaison avec une des bornes 12, 13 ou 24, le courant circulant dans l'entrée de l'opto-coupleur est, aussi, diminué ou interrompu. L'opto-coupleur ne détecte plus de signal de présence de courant et le décodeur commande l'oscillateur 28 pour l'ouverture du disjoncteur.

Le circuit d'alimentation 27 comporte de préférence une isolation électrique entre l'entrée et la sortie. Les dispositifs de codage 25 et de décodage 31 décrits ci-dessus fonctionnent avec des signaux continus. Mais, pour augmenter la sécurité, et notamment éviter qu'une liaison extérieure entre les bornes 12 et 24 empêche l'ouverture du disjoncteur par le dispositif 2, les dispositifs 25 et 31 peuvent fonctionner avec des signaux particuliers ou codés de manière complexe. Par exemple, le circuit 25 peut commander le transistor avec un signal périodique, de période et de rapport cycliques prédéterminés.

Tant que le circuit de décodage 31 reçoit ce signal périodique de caractéristiques prédéterminées, la commande d'ouverture du disjoncteur n'est pas activée. Si ce signal disparaît ou est modifié, le dispositif 11 commande l'ouverture du disjoncteur.

Le signal, produit par le circuit de codage 25 et décodé par le circuit 31 peut être aussi un signal codé binaire offrant de plus grandes possibilités de codage et de sécurité.

Pour assurer un fonctionnement plus souple du disjoncteur, il est possible de ne déclencher la commande d'ouverture que si le signal est absent pendant un temps prédéterminé et si une tension d'alimentation suffisante est présente sur le circuit 27.

Selon un troisième mode de réalisation de l'invention, représenté sur le schéma de la figure 3, l'alimentation du circuit 25 et la transmission du signal codé par le circuit 2 se font avec une liaison à deux fils connectés aux deux bornes de commande 12 et 13.

La sortie du circuit d'alimentation 27 est connectée entre les bornes 12 et 13 de commande, à travers un circuit 32 de limitation de courant. Un circuit 33 de lecture du signal, connecté entre les bornes de commande (12 et 13) et le circuit 31 de décodage, lit un signal de tension ou de courant reçu sur les bornes 12 et 13. Le circuit 33 peut comporter un dispositif d'isolation électrique.

Le dispositif de contrôle 2 comporte le circuit de contrôle 21, le circuit de codage 25 et un transistor 34 commandé par ledit circuit 25. Le transistor 34 est connecté entre les deux lignes de liaison du circuit 2 aux bornes 12 et 13. Le circuit 25 envoie un signal au disjoncteur en faisant conduire de manière impulsionnelle le transistor 34.

L'alimentation du circuit 25 est prise sur les liaisons aux bornes 12 et 13. Lorsque le transistor est bloqué, une diode 35 connectée entre le transistor et le circuit 25 permet de charger un condensateur 36, connecté en parallèle sur le circuit 25. Pendant la conduction du transistor 34, la diode 35 empêche la décharge du condensateur 36 vers le transistor. Le circuit 25 est alors alimenté par le condensateur 36.

Dans le mode de réalisation de la figure 3, le circuit de décodage 31 commande directement le relais 10. Si le circuit 31 ne reconnaît pas le signal transmis par le circuit 25, un signal de commande d'ouverture est envoyé au relais 10. Le signal de commande d'ouverture peut être codé avec une grande sécurité.

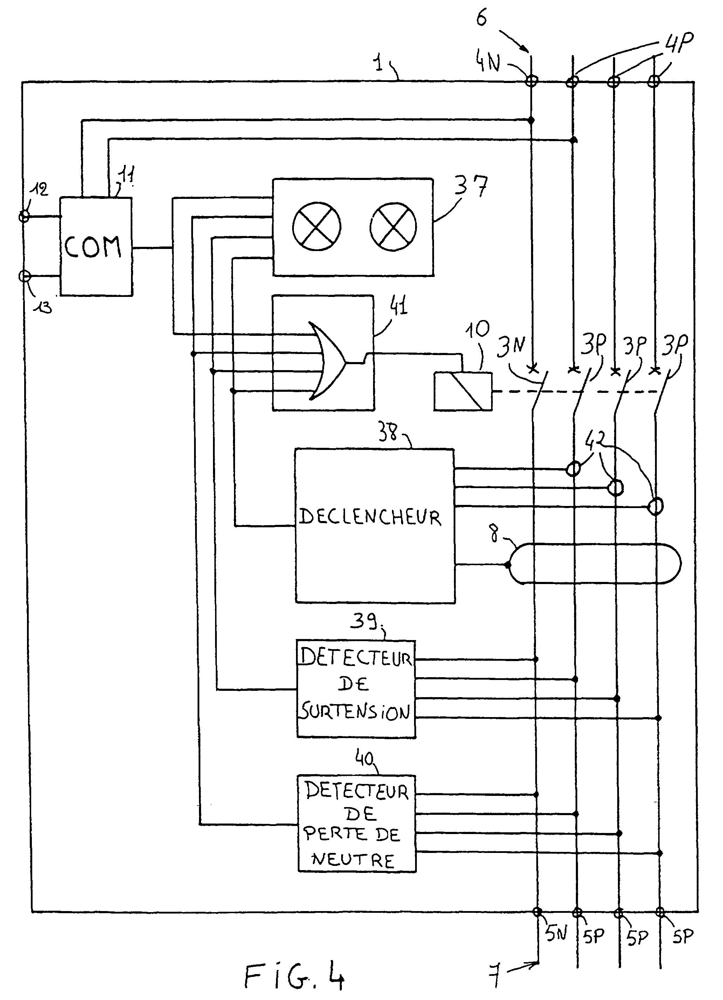

La figure 4 représente le schéma complet d'un disjoncteur tétrapolaire selon un mode de réalisation de l'invention. La ligne 6 d'alimentation et la ligne 7 de distribution comportent 4 conducteurs, un conducteur neutre et trois conducteurs de phase. Le disjoncteur 1 comporte quatre contacts principaux, un 3N pour le neutre et trois 3P pour les phases, quatre bornes de raccordement amont, une pour le neutre 4N et trois pour les phases 4P, et quatre bornes de raccordement aval, une pour le neutre 5N et trois pour les phases 5P.

Le relais de déclenchement 10 commande l'ouverture des quatre contacts principaux 3N et 3P. L'alimentation du circuit de commande 11 est prise sur des laissions entre les contacts principaux et les bornes de raccordement amont. Les bornes 12 et 13 véhiculent les signaux de commande d'ouverture du disjoncteur.

Dans ce mode de réalisation le disjoncteur comporte un dispositif de visualisation 37 connecté à une sortie du dispositif de commande 11. Cette sortie peut être la même que celle utilisée pour commander le relais 10. Le dispositif permet de visualiser une ouverture provoquée par le dispositif de commande et de la différencier ainsi d'une ouverture due à un défaut électrique.

Le disjoncteur de la figure 4 comporte un déclencheur 38, un détecteur de surtension 39 et un détecteur de perte de neutre 40 comportant chacun une sortie pour commander le déclenchement du disjoncteur. Pour centraliser la commande du relais 10, le disjoncteur comporte un circuit 41 de centralisation des commandes d'ouverture comportant des entrées connectées aux sorties du circuit de commande 11, du déclencheur 38, et des détecteurs 39 et 40. Une sortie du circuit 41 est connectée au relais 10 de déclenchement.

Le déclencheur 38 a une entrée connectée au tore 8 et trois entrées connectées à des capteurs 42 de courant situés sur des conducteurs reliant les contacts 3P aux bornes 5P. Le déclencheur 38 permet de protéger l'installation électrique contre les surcharges en courant, les court-circuits ou les fuites à la terre. Les détecteurs 39 et 40 ont des entrées connectées aux conducteurs reliant les contacts principaux 3N et 3P aux bornes de raccordement aval 5N et 5P.

Le dispositif de visualisation 37 comporte des entrées connectées aux sorties du déclencheur et des détecteurs de surtension et de perte de neutre. Le dispositif 37 permet ainsi de visualiser sur un premier voyant l'ouverture provoquée par le dispositif 11 et sur un ou plusieurs seconds voyants de manière individuelle ou groupée, l'ouverture provoquée par le déclencheur 38 ou les détecteurs 39 et 40.

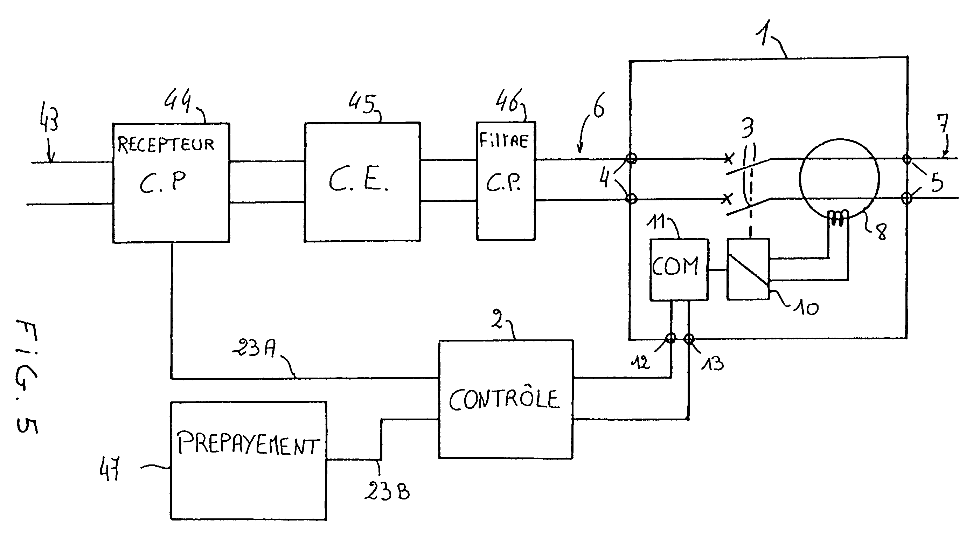

Un dispositif de distribution selon un mode de réalisation de l'invention mis en place dans une installation électrique est représenté sur la figure 5. Un réseau de distribution 43 alimente la ligne d'alimentation 6 à travers un récepteur 44 de télécommande, un compteur 45 d'énergie électrique et un filtre 46 reliés en série.

Des signaux de télécommande circulent sur le réseau 43 sous la forme de courants porteurs. Le récepteur 44 comporte une sortie connectée à une première entrée du dispositif 2 de contrôle. Lorsque des signaux de télécommande sont transmis sur le réseau 43, le récepteur 44 les détecte et envoie des signaux 23A d'information au dispositif 2 de contrôle. Si les signaux d'information comportent un ordre d'ouverture, le dispositif 2 modifie ou interrompt le signal circulant entre les bornes 12 et 13 et le disjoncteur 1 est commandé en ouverture.

Le filtre 46 arrête les courants porteurs avant le disjoncteur et évite qu'une installation électrique connectée en aval du disjoncteur soit perturbée par des signaux de télécommande.

Le dispositif de contrôle de la figure 5 comporte une seconde entrée connectée à un dispositif 47 de prépayement. Le dispositif 47 envoie des signaux d'information 23B au dispositif de contrôle 2 pour autoriser la fermeture ou provoquer l'ouverture du disjoncteur en fonction de données de prépayement. Les données de prépayement sont représentatives, par exemple, d'une quantité d'énergie électrique achetée ou d'une durée de connexion préenregistrée.

Le dispositif 2 de distribution peut utiliser de manière indépendante ou simultanément les deux signaux 23A et 23B.

Dans les modes de réalisation décrits ci-dessus, les liaisons entre le dispositif de commande 11 du disjoncteur et le dispositif de contrôle 2 sont réalisées avec des connexions électriques sur des bornes 12 et 13. Mais il est possible dans d'autres modes de réalisation de l'invention, de réaliser des liaisons non électriques. Par exemple, entre les dispositifs 2 et 11 un signal peut être transmis sous forme optique en utilisant un émetteur à diode électroluminescente et un phototransistor. Il est également possible d'utiliser entre les dispositifs 2 et 11 une liaison à fibre optique.

L'invention peut être appliquée à tout type de disjoncteur quelque soit le nombre de pôles à protéger ou le type de projection qu'il exerce sur l'installation électrique.

## Revendications

1. Disjoncteur électrique (1) comportant des contacts électriques (3, 3N, 3P) principaux destinés à interrompre un courant électrique dans une installation, un dispositif (8, 9, 10, 38, 41) de déclenchement commandant l'ouverture des contacts principaux lorsqu'un défaut électrique se produit dans l'installation, des bornes de commande d'ouverture recevant un signal de commande et un dispositif de commande d'ouverture connecté entre les bornes de commande d'ouverture et le dispositif de déclenchement pour commander l'ouverture du disjoncteur en fonction du signal de commande,
disjoncteur **caractérisé en ce que** le dispositif (11) de commande comporte :
- des moyens de détection (19, 29, 30, 33) d'un signal électrique connectés à au moins une des bornes (12, 13, 24) de commande d'ouverture,
- des moyens de comparaison (19, 31) connectés entre les moyens de détection et le dispositif de déclenchement pour comparer le signal électrique à une valeur prédéterminée et provoquer une commande d'ouverture du disjoncteur si le signal est inférieur à la valeur prédéterminée.

2. Disjoncteur selon la revendication 1, **caractérisé en ce que** le dispositif de commande comporte un circuit (27) d'alimentation électrique ayant une entrée connectée aux contacts principaux et une sortie connectée à une des bornes (12, 13, 24) de commande.

3. Disjoncteur selon l'une des revendications 1 ou 2 **caractérisé en ce que** les moyens de détection comportent des moyens d'isolation électrique (29, 33) connectés entre les bornes de commande d'ouverture et les moyens de comparaison.

4. Disjoncteur selon la revendication 3 **caractérisé en ce que** les moyens d'isolation électrique comportent un opto-coupleur (29) connecté entre au moins une borne et les moyens de comparaison.

5. Disjoncteur selon l'une quelconque des revendications 1 à 4 **caractérisé en ce que** les moyens de comparaison comportent des moyens de décodage (31) connectés entre les moyens de détection et le dispositif de déclenchement.

6. Disjoncteur selon la revendication 5 **caractérisé en ce que** les moyens de comparaison (19, 31) commandent également l'ouverture du disjoncteur si le signal détecté par les moyens de détection (19, 29, 33) n'a pas des caractéristiques prédéterminées.

7. Disjoncteur selon l'une des revendications 5 ou 6 **caractérisé en ce que** les moyens de comparaison (19, 31) commandent l'ouverture du disjoncteur si le signal détecté par les moyens de détection (19, 29, 33) a une valeur continue inférieure à une valeur prédéterminée.

8. Disjoncteur selon l'une des revendications 5 ou 6 **caractérisé en ce que** les moyens de comparaison (31) commandent également l'ouverture du disjoncteur si le signal détecté par les moyens de détection (29, 33) a une valeur différente d'un signal périodique de période et de rapport cyclique prédéterminés.

9. Disjoncteur selon l'une des revendications 5 ou 6 **caractérisé en ce que** les moyens de comparaison (31) commandent également l'ouverture du disjoncteur si le signal détecté par les moyens de détection (29, 33) a une valeur différente d'un signal codé binaire prédéterminé.

10. Disjoncteur selon l'une quelconque des revendications 1 à 9 **caractérisé en ce qu'**il comporte un dispositif de visualisation (37) connecté aux moyens de commande pour visualiser si l'ouverture du disjoncteur a été provoquée par un signal de commande.

11. Disjoncteur selon la revendication 10 **caractérisé en ce que** le dispositif de visualisation (37) comporte un premier voyant pour visualiser une ouverture du disjoncteur provoquée par un signal de commande, et au moins un second voyant pour visualiser une ouverture provoquée par des dispositifs (38, 39, 40) de protection électrique.

12. Disjoncteur selon l'une quelconque des revendications 1 à 11 **caractérisé en ce que** le dispositif de commande (11) comporte des moyens de validation (20, 27) connectés aux contacts principaux (3, 3N, 3P) pour autoriser l'ouverture du disjoncteur par le signal de commande lorsqu'une tension d'alimentation est présente sur lesdits contacts principaux du disjoncteur.

13. Dispositif de distribution électrique **caractérisé en ce qu'**il comporte un disjoncteur selon l'une quelconque des revendications 1 à 12 et un dispositif de contrôle (2) connecté aux bornes (12, 13, 24) de commande.

14. Dispositif de distribution électrique selon la revendication 13 **caractérisé en ce que** le dispositif de contrôle (2) comporte des moyens (22, 26) d'interruption connectés aux bornes (12, 13, 24) de commandes du disjoncteur pour interrompre le courant circulant entre deux desdites bornes (12, 13, 24).

15. Dispositif de distribution électrique selon l'une des revendications 13 ou 14 **caractérisé en ce que** le dispositif de contrôle (2) comporte des moyens de codage (25) pour coder le signal de commande envoyé aux bornes de commande (12, 13, 24) du disjoncteur.

16. Dispositif de distribution électrique selon l'une quelconque des revendications 13 à 15 **caractérisé en ce qu'** une entrée du dispositif (2) de contrôle est connectée à une sortie d'un dispositif (44) de réception à courants porteurs.

17. Dispositif de distribution électrique selon l'une quelconque des revendications 13 à 15 **caractérisé en ce qu'** une entrée du dispositif (2) de contrôle est connectée à une sortie d'un dispositif de pré-payement (47).

## Patentansprüche

1. Leistungsschalter (1) mit elektrischen Hauptkontakten (3, 3N, 3P) zur Unterbrechung eines elektrischen Stroms in einer Installation, wobei eine Auslösevorrichtung (8, 9, 10, 38, 41) die Abschaltung der Hauptkontakte bei Auftreten eines elektrischen Fehlers in der Installation steuert, mit Ausschaltsteuerklemmen, die mit einem Steuersignal beaufschlagt werden, sowie mit einer Ausschaltsteuereinrichtung, die zwischen die Ausschaltsteuerklemmen und die Auslösevorrichtung geschaltet ist, um die Abschaltung des Leistungsschalters in Abhängigkeit vom Steuersignal zu steuern,
welcher Leistungsschalter **dadurch gekennzeichnet ist, daß** die Steuereinrichtung (11)
- zur Erfassung eines elektrischen Signals dienende Detektionsmittel (19, 29, 30, 33), die an mindestens eine der Ausschaltsteuerklemmen (12, 13, 24) angeschlossen sind, sowie
- Vergleichsmittel (19, 31) umfaßt, die zwischen die Detektionsmittel und die Auslösevorrichtung geschaltet sind, um das elektrische Signal mit einem festgelegten Wert zu vergleichen und eine Ausschaltsteuerung des Leistungsschalters zu bewirken, wenn das Signal den festgelegten Wert unterschreitet.

2. Leistungsschalter nach Anspruch 1, **dadurch gekennzeichnet, daß** die Steuereinrichtung eine Stromversorgungsschaltung (27) mit einem an die Hauptkontakte angeschlossenen Eingang sowie einem an eine der Steuerklemmen (12, 13, 24) angeschlossenen Ausgang umfaßt.

3. Leistungsschalter nach einem der Ansprüche 1 oder 2, **dadurch gekennzeichnet, daß** die Detektionsmittel zwischen die Ausschaltsteuerklemmen und die Vergleichsmittel geschaltete Mittel zur galvanischen Trennung (29, 33) umfassen.

4. Leistungsschalter nach Anspruch 3, **dadurch gekennzeichnet, daß** die Mittel zur galvanischen Trennung einen Optokoppler (29) umfassen, der zwischen mindestens eine Klemme und die Vergleichsmittel geschaltet ist.

5. Leistungsschalter nach irgendeinem der Ansprüche 1 bis 4, **dadurch gekennzeichnet, daß** die Vergleichsmittel zwischen die Detektionsmittel und die Auslösevorrichtung geschaltete Dekodiermittel (31) umfassen.

6. Leistungsschalter nach Anspruch 5, **dadurch gekennzeichnet, daß** die Vergleichsmittel (19, 31) auch dann die Abschaltung des Leistungsschalters steuern, wenn das durch die Detektionsmittel (19, 29, 33) erfaßte Signal nicht bestimmte Eigenschaften aufweist.

7. Leistungsschalter nach einem der Ansprüche 5 oder 6, **dadurch gekennzeichnet, daß** die Vergleichsmittel (19, 31) die Abschaltung des Leistungsschalters steuern, wenn das durch die Detektionsmittel (19, 29, 33) erfaßte Signal einen gleichbleibenden Wert aufweist, das unter einem festgelegten Wert liegt.

8. Leistungsschalter nach einem der Ansprüche 5 oder 6, **dadurch gekennzeichnet, daß** die Vergleichsmittel (31) auch dann die Abschaltung des Leistungsschalters steuern, wenn das durch die Detektionsmittel (29, 33) erfaßte Signal einen Wert aufweist, der von einem periodischen Signal mit einer festgelegten Periodendauer und einem festgelegten Periodenverhältnis abweicht.

9. Leistungsschalter nach einem der Ansprüche 5 oder 6, **dadurch gekennzeichnet, daß** die Vergleichsmittel (31) auch dann die Abschaltung des Leistungsschalters steuern, wenn das durch die Detektionsmittel (29, 33) erfaßte Signal einen Wert aufweist, der von einem festgelegten, kodierten Binärsignal abweicht.

10. Leistungsschalter nach irgendeinem der Ansprüche 1 bis 9, **dadurch gekennzeichnet, daß** er eine an die Steuermittel angeschlossene Anzeigevorrichtung (37) zur Anzeige einer Abschaltung des Leistungsschalters aufgrund eines Steuersignals umfaßt.

11. Leistungsschalter nach Anspruch 10, **dadurch gekennzeichnet, daß** die Anzeigevorrichtung (37) einen ersten Leuchtmelder zur Anzeige einer Abschaltung des Leistungsschalters aufgrund eines Steuersignals, sowie mindestens einen zweiten Leuchtmelder zur Anzeige einer Abschaltung des Leistungsschalters durch elektrische Schutzeinrichtungen (38, 39, 40) umfaßt.

12. Leistungsschalter nach irgendeinem der Ansprüche 1 bis 11, **dadurch gekennzeichnet, daß** die Steuereinrichtung (11) an die Hauptkontakte (3, 3N, 3P) angeschlossene Validiermittel (20, 27) umfaßt, die dazu dienen, die Abschaltung des Leistungsschalters durch das Steuersignal freizugeben, wenn eine Versorgungsspannung an den genannten Hauptkontakten des Leistungsschalters anliegt.

13. Elektrische Verteilungseinrichtung **dadurch gekennzeichnet, daß** sie einen Leistungsschalter nach irgendeinem der Ansprüche 1 bis 12 sowie eine Kontrolleinrichtung (2) umfaßt, die an die Steuerklemmen (12, 13, 24) angeschlossen ist.

14. Elektrische Verteilungseinrichtung nach Anspruch 13, **dadurch gekennzeichnet, daß** die Kontrolleinrichtung (2) an die Steuerklemmen (12, 13, 24) des Leistungsschalters angeschlossene Unterbrechermittel (22, 26) umfaßt, um den Stromfluß zwischen zwei der genannten Klemmen (12, 13, 24) zu unterbrechen.

15. Elektrische Verteilungseinrichtung nach Anspruch 13 oder 14, **dadurch gekennzeichnet, daß** die Kontrolleinrichtung (2) Kodiermittel (25) zur Kodierung des an die Steuerklemmen (12, 13, 24) des Leistungsschalters gesandten Steuersignals umfaßt.

16. Elektrische Verteilungseinrichtung nach irgendeinem der Ansprüche 13 bis 15, **dadurch gekennzeichnet, daß** ein Eingang der Kontrolleinrichtung (2) an einen Ausgang einer Trägerstrom-Empfangseinrichtung (44) angeschlossen ist.

17. Elektrische Verteilungseinrichtung nach irgendeinem der Ansprüche 13 bis 15, **dadurch gekennzeichnet, daß** ein Eingang der Kontrolleinrichtung (2) an einen Ausgang einer Vorkasseeinrichtung (47) angeschlossen ist.

## Claims

1. Electrical circuit breaker (1) comprising main electrical contacts (3, 3N, 3P) designed to interrupt an electrical current in an installation, a trip device (8, 9, 10, 38, 41) commanding opening of the main contacts when an electrical fault occurs in the installation, opening control terminals receiving a control signal and an opening control device connected between the opening control terminals and the trip device to command opening of the circuit breaker according to the control signal, circuit breaker **characterized in that** the control device (11) comprises:
- detection means (19, 29, 30, 33) for detecting an electrical signal connected to at least one of the opening control terminals (12, 13, 24),
- comparison means (19, 31) connected between the detection means and the trip device to compare the electrical signal with a preset value and to cause an opening command of the circuit breaker if the signal is lower than the preset value.

2. Circuit breaker according to claim 1 **characterized in that** the control device comprises an electrical power supply circuit (27) having an input connected to the main contacts and an output connected to one of the control terminals (12, 13, 24).

3. Circuit breaker according to one of the claims 1 or 2 **characterized in that** the detection means comprise electrical insulation means (29, 33) connected between the opening control terminals and the comparison means.

4. Circuit breaker according to claim 3 **characterized in that** the electrical insulation means comprise an opto-coupler (29) connected between at least one terminal and the comparison means.

5. Circuit breaker according to any one of the claims 1 to 4 **characterized in that** the comparison means comprise decoding means (31) connected between the detection means and the trip device.

6. Circuit breaker according to claim 5 **characterized in that** the comparison means (19, 31) also command opening of the circuit breaker if the signal detected by the detection means (19, 29, 33) does not have predetermined characteristics.

7. Circuit breaker according to one of the claims 5 or 6 **characterized in that** the comparison means (19, 31) command opening of the circuit breaker if the signal detected by the detection means (19, 29, 33) has a continuous value lower than a preset value.

8. Circuit breaker according to one of the claims 5 or 6 **characterized in that** the comparison means (31) also command opening of the circuit breaker if the signal detected by the detection means (29, 33) has a value different from a periodic signal of preset period and duty factor.

9. Circuit breaker according to one of the claims 5 or 6 **characterized in that** the comparison means (31) also command opening of the circuit breaker if the signal detected by the detection means (29, 33) has a value different from a preset encoded binary signal.

10. Circuit breaker according to any one of the claims 1 to 9 **characterized in that** it comprises a display device (37) connected to the control means to display whether opening of the circuit breaker was caused by a control signal.

11. Circuit breaker according to claim 10 **characterized in that** the display device (37) comprises a first indicator to indicate opening of the circuit breaker caused by a control signal and at least a second indicator to indicate opening caused by electrical protection devices (38, 39, 40).

12. Circuit breaker according to any one of the claims 1 to 11 **characterized in that** the control device (11) comprises validation means (20, 27) connected to the main contacts (3, 3N, 3P) to enable opening of the circuit breaker by the control signal when a supply voltage is present on said main contacts of the circuit breaker.

13. Electrical distribution device **characterized in that** it comprises a circuit breaker according to any one of the claims 1 to 12 and a control device (2) connected to the control terminals (12, 13, 14).

14. Electrical distribution device according to claim 13 **characterized in that** the control device (2) comprises interruption means (22, 26) connected to the circuit breaker control terminals (12, 13, 24) to interrupt the current flowing between two of said terminals (12, 13, 24).

15. Electrical distribution device according to one of the claims 13 or 14 **characterized in that** the control device (2) comprises encoding means (25) to encode the control signal sent to the circuit breaker control terminals (12, 13, 24).

16. Electrical distribution device according to any one of the claims 13 to 15 **characterized in that** an input of the control device (2) is connected to an output of a carrier current receiver device (44).

17. Electrical distribution device according to any one of the claims 13 to 15 **characterized in that** an input of the control device (2) is connected to an output of a prepayment device (47).
